# EUROPÄISCHE PATENTANMELDUNG

(11) **EP 1 406 318 A2**
(43) Veröffentlichungstag der Anmeldung: **07.04.2004**
(21) Anmeldenummer: 03020818.5
(22) Anmeldetag: 12.09.2003
(51) Int. Cl.: H01L 41/09

(54) **Piezoelektrischer Biegewandler**

(30) Priorität: 04.10.2002 DE 10246307
(71) Anmelder: Argillon GmbH, 96257 Redwitz (DE)
(72) Erfinder: Riedel, Michael, 96472 Rödental (DE); Schmid, Andreas, 96247 Michelau (DE)
(74) Vertreter: Tergau & Pohl Patentanwälte

(57) **Zusammenfassung**

Ein piezoelektrischer Biegewandler (1) mit einem länglichen Tragkörper (2), der an wenigstens einer Längsseite (4 bzw. 8) mit einem Piezo-Körper (6 bzw. 10) bestückt ist, soll im Hinblick auf seine charakteristischen Einsatzparameter, insbesondere hinsichtlich seiner Stellwege und Stellkräfte, an eine besonders große Vielzahl möglicher Einsatzzwecke anpassbar sein. Dazu ist im Inneren des Tragkörpers (2) neben einem Trägermaterial (24a) eine Anzahl von aus einem weiteren Material (24b) mit im Vergleich zum Trägermaterial (24a) unterschiedlichen mechanischen Eigenschaften aufgebauten Strukturelementen (26) angeordnet.

## Beschreibung

Die Erfindung bezieht sich auf einen piezoelektrischen Biegewandler mit einem länglichen Tragkörper, der an wenigstens einer Längsseite mit einem Piezo-Körper bestückt ist.

Für einen piezoelektrischen Biegewandler gibt es eine Vielzahl von technischen Anwendungen. Solche Anwendungen sind z.B. als piezoelektrischer Druckerkopf für einen Tintenstrahldrucker, als Schallaufnehmer oder -erzeuger für Mikrophone bzw. Lautsprecher, als Sensor für Beschleunigungs- oder Druckmessung, als Stell- oder Positionierungselement, sogenannter Aktor, in Braille-Zeilen in Lesegeräten für Blinde, in Textilmaschinen oder in Pneumatikventilen.

Dazu wird der piezoelektrischen Biegewandler in ein durch die Anwendung vorgegebenes Gehäuse eingespannt. An den dem Piezo-Körper zugeordneten Elektroden kann dann, insbesondere über elektrische Leiter des Tragkörpers, eine Ansteuerspannung angelegt werden, die eine Längenkontraktion des Piezo-Körpers hervorruft. Aufgrund der Verbindung aus dem kontrahierenden Piezo-Körper und dem nicht-kontrahierenden Tragkörper resultiert eine in ihrem Ausmaß von der Ansteuerspannung abhängige Auslenkung eines uneingespannten Längenabschnitts des piezoelektrischen Biegewandlers senkrecht zur Längsrichtung.

Ein solcher piezoelektrischer Biegewandler dient somit vorrangig zur Ausnutzung des indirekten oder reziproken piezoelektrischen Effektes, d.h. zur Umwandlung von elektrischer in mechanische Energie.

Aus den mechanischen Eigenschaften des Tragkörpers und des Piezo-Körpers ergeben sich die mechanischen Eigenschaften des piezoelektrischen Biegewandlers. Die elektrische Kontaktierung zwischen den Elektroden des meist aus einer Piezo-Keramik bestehenden Piezo-Körpers und dem Tragkörper erfolgt üblicherweise über elektrische Leiter aus elektrisch leitfähigen Materialien wie Metallen, Carbon oder Carbonfaserstoffen. Bei der Verwendung eines nicht leitfähigen Materials für den Tragkörper, wie z.B. von Polyimid, werden zusätzliche Leiter, z.B. aus Metall oder Carbon, verwendet.

Der Erfindung liegt die Aufgabe zugrunde, einen piezoelektrischen Biegewandler der oben genannten Art anzugeben, der im Hinblick auf seine charakteristischen Einsatzparameter an eine besonders große Vielzahl möglicher Einsatzzwecke anpassbar ist.

Diese Aufgabe wird erfindungsgemäß gelöst, indem im Inneren des ein Trägermaterial umfassenden Tragkörpers eine Anzahl von aus einem weiteren Material mit im Vergleich zum Trägermaterial unterschiedlichen mechanischen Eigenschaften aufgebauten Strukturelementen angeordnet ist.

Die Erfindung geht dabei von der Überlegung aus, dass als charakteristische Parameter für den Einsatz des piezoelektrischen Biegewandlers insbesondere dessen Stellweg und dessen Stellkraft von Interesse sind. Zwar verhalten sich diese Parameter abhängig von den Materialeigenschaften des Tragkörpers einerseits und des Piezo-Körpers andererseits reziprok zueinander. Allerdings kann zumindest der insgesamt verfügbare Parameterbereich in der Art eines zusätzlichen Freiheitsgrades beeinflusst werden, indem der Tragkörper hinsichtlich seiner mechanischen Eigenschaften geeignet variiert wird. Daher sollten unter Umgehung der eigentlich inhärenten oder innewohnenden Materialeigenschaften die mechanischen Eigenschaften des Tragkörpers jeweils im Hinblick auf die spezifische Verwendung des piezoelektrischen Biegewandlers bei dessen Herstellung einfach und gezielt eingestellt werden können. Dies kann ein in der Art einer Hybrid-Bauweise ausgeführter Tragkörper ermöglichen, bei dem additiv zum bisherigen Trägermaterial zur Schaffung eines neuen funktionalen Parameters ein weiteres Material zum Einsatz kommt, das die Biegeeigenschaften des piezoelektrischen Biegewandlers wie gewünscht beeinflusst. Die gezielte Einstellung der Biegeeigenschaften erfolgt daher durch das Einbringen von aus dem weiteren Material aufgebauten Strukturelementen in den Tragkörper mit im Vergleich zum Trägermaterial unterschiedlichen mechanischen Eigenschaften.

Bevorzugte Ausgestaltungen sind in den Unteransprüchen angegeben.

Zur gezielten Einstellung der Biegeeigenschaften des piezoelektrischen Biegewandlers bei dessen Herstellung ist der Tragkörper des Piezo-Körpers zweckmäßigerweise partiell mit starren und flexiblen Materialien ausgestaltet. Dazu weisen die Strukturelemente des weiteren Materials vorzugsweise einen Elastizitätsmodul (E-Modul) auf, der verschieden von dem des Trägermaterials. Der Elastizitätsmodul (E-Modul) ist eine Kennzahl für die Festigkeit eines Materials. Durch die Berücksichtigung dieses Parameters ist die Arbeitsgerade des piezoelektrischen Biegewandlers gezielt in Richtung größerer Stellkräfte verschoben, wenn Strukturelemente mit größeren E-Modulen im Vergleich zu denen des Trägermaterials der ersten Materialkategorie in den Tragkörper eingebracht sind. Alternativ erfolgt eine gezielte Verschiebung der Arbeitsgerade des piezoelektrischen Biegewandlers in Richtung größerer Stellwege durch Strukturelemente mit entsprechend kleineren E-Modulen.

Neben der geeigneten Materialwahl ist zur gezielten Anpassung der Biegeeigenschaften des piezoelektrischen Biegewandlers an einen vorgegebenen Einsatzzweck, insbesondere für lokal unterschiedliche mechanische Wirkungen und Beanspruchungen, die Positionierung der Strukturelemente im Tragkörper in besonders vorteilhafter Ausgestaltung auf den Bestückungsbereich mit dem Piezo-Körper beschränkt. Um beispielsweise den piezoelektrischen Biegewandler ohne mechanische Schädigungen des Piezo-Körpers fest in einem Gehäuse einspannen zu können, ist der Tragkörper des Piezo-Körpers zweckmäßigerweise von einem vergleichsweise flexiblen Trägermaterial, also einem Trägermaterial mit vergleichsweise kleinem E-Modul, gebildet und vorzugsweise im Bestückungsbereich mit dem Piezo-Körper zur Versteifung mit Strukturelementen des weiteren Materials mit vergleichsweise großem E-Modul ausgestattet. Damit werden ansonsten mögliche Beeinträchtigungen der Funktion oder des Wirkungsgrades des piezoelektrischen Biegewandlers reduziert.

Für eine an einem vorgegebenen Einsatzzweck orientierte gezielte Leitungsführung und ferner für eine Vielfalt an Verschaltungsmöglichkeiten bei gleichzeitig gewünschter kompakter Bauweise des piezoelektrischen Biegewandlers weist der Tragkörper vorzugsweise mehrere Tragkörperschichten mit diesen zugeordneten Bestückungsebenen auf.

Zum Schutz vor mechanischen oder chemischen Einflüssen sind die elektrischen Leiter für den Piezo-Körper vorzugsweise im Inneren, in besonders vorteilhafter Weiterbildung ganz oder teilweise in den innen liegenden Bestückungsebenen des Tragkörpers angeordnet.

Damit die elektrischen Leiter für den Piezo-Körper an zur Herstellung einer vorgegebenen Verschaltung geeigneten Verbindungsstellen miteinander oder mit dem Piezo-Körper verknüpfbar sind, sind vorteilhafterweise quer zu den Tragkörperschichten verlaufende Durchkontaktierungen, sogenannte Vias, vorgesehen. Bei den Durchkontaktierungen handelt es sich um elektrisch leitfähige Materialien, die in den Tragkörper zweckmäßigerweise in ganz oder teilweise durchsetzenden Ausnehmungen oder Durchbrechungen quer zu dessen Ausdehnungsebene eingebracht sind.

Um die Herstellung des piezoelektrischen Biegewandlers zu vereinfachen und insbesondere sein Anwendungsgebiet auf dem Gebiet der Mikrosystemtechnik mit einem geringen Raumangebot zu erweitern, übernehmen die Strukturelemente des weiteren Materials zweckmäßigerweise eine Doppelfunktion. Diese Doppelfunktion besteht darin, dass die Strukturelemente neben ihrer Eigenschaft als lokaler Regulator für spezifische mechanische Biegeeigenschaften des piezoelektrischen Biegewandlers in besonders vorteilhafter Ausgestaltung zugleich als elektrische Leiter für den Piezo-Körper ausgebildet sind und als solche fungieren.

Um des Weiteren eine modulare und insbesondere im Hinblick auf mikrosystemtechnische Anwendungen zugleich eine zumindest kompakte oder sogar integrierte Bauweise des piezoelektrischen Biegewandlers in Verbindung mit der für dessen Betrieb verwendeten Elektronik zu gewährleisten, ist vorzugsweise direkt auf und/oder im Inneren des Tragkörpers eine Anzahl von Komponenten einer Ansteuer-, Sensor- oder Arbeitselektronik untergebracht.

Eine Verwendung eines piezoelektrischen Biegewandlers der oben genannten Art erfolgt vorzugsweise als Stellglied, beispielsweise mit Antriebs- oder Abdichtfunktion, für mikrosystemtechnische Anwendungen, wie beispielsweise Mikropumpen, Mikrodispensiersysteme und/oder Mikroventile.

Die mit der Erfindung erzielten Vorteile bestehen insbesondere darin, dass durch den zusätzlichen Einbau von aus einem weiteren Material aufgebauten Strukturelementen in den Tragkörper mit im Vergleich zum Trägermaterial unterschiedlichen mechanischen Eigenschaften bei dessen Herstellung eine einfache und freie Einstellbarkeit der Biegeeigenschaften, insbesondere im Hinblick auf die Stellkräfte und Stellwege, des piezoelektrischen Biegewandlers für einen vorgegebenen Einsatzzweck zuverlässig ermöglicht ist.

Gerade durch die geeignete Wahl des Elastizitätsmoduls (E-Moduls) der Strukturelemente verschieden zu dem des Trägermaterials und durch die gezielte Positionierung der Strukturelemente im Bestückungsbereich mit dem Piezo-Körper kann der piezoelektrische Biegewandler unter Umgehung der eigentlich charakteristischen Materialeigenschaften des Tragkörpers nunmehr zusätzlich vorgesehene Funktionen und Wirkungen erfüllen. Beispielsweise können die beim Einspannen des piezoelektrischen Biegewandlers in ein Gehäuse, z.B. ein Ventilgehäuse, ansonsten häufig auftretenden mechanischen Beanspruchungen des Piezo-Körpers, die die Funktion oder den Wirkungsgrad des piezoelektrischen Biegewandlers beeinträchtigen können, vermieden werden, indem der Tragkörper des Piezo-Körpers von einem vergleichsweise flexiblen Trägermaterial gebildet ist und im Bestückungsbereich mit dem Piezo-Körper zur Versteifung mit Strukturelementen des weiteren Materials mit vergleichsweise großem E-Modul ausgestattet ist.

Der Einsatz der Strukturelemente in doppelter Funktion, nämlich sowohl als elektrische Leiter für den Piezo-Körper als auch als lokaler Regulator für spezifische mechanische Biegeeigenschaften des piezoelektrischen Biegewandlers, vereinfacht dessen Herstellung und ist insbesondere für mikrosystemtechnische Anwendungen von besonderer Bedeutung.

Ein Ausführungsbeispiel der Erfindung wird anhand einer Zeichnung näher erläutert. Darin zeigen:
- Figur 1: einen piezoelektrischen Biegewandler in vergrößerter perspektivischer und teilweise explodierter Darstellung,
- Figur 2: den piezoelektrischen Biegewandler aus Figur 1 im Querschnitt,
- Figur 3: eine Draufsicht auf eine obere Bestückungsebene der ersten Tragkörperschicht des piezoelektrischen Biegewandlers aus den Figuren 1 und 2,
- Figur 4: eine Draufsicht auf eine mittlere Bestückungsebene zwischen einer ersten und zweiten Tragkörperschicht des piezoelektrischen Biegewandlers aus den Figuren 1 und 2, und
- Figur 5: eine Draufsicht auf eine untere Bestückungsebene zwischen der zweiten Tragkörperschicht und einem zweiten Piezo-Körper des piezoelektrischen Biegewandlers aus den Figuren 1 und 2.

Gleiche Teile sind in allen Figuren mit denselben Bezugszeichen versehen.

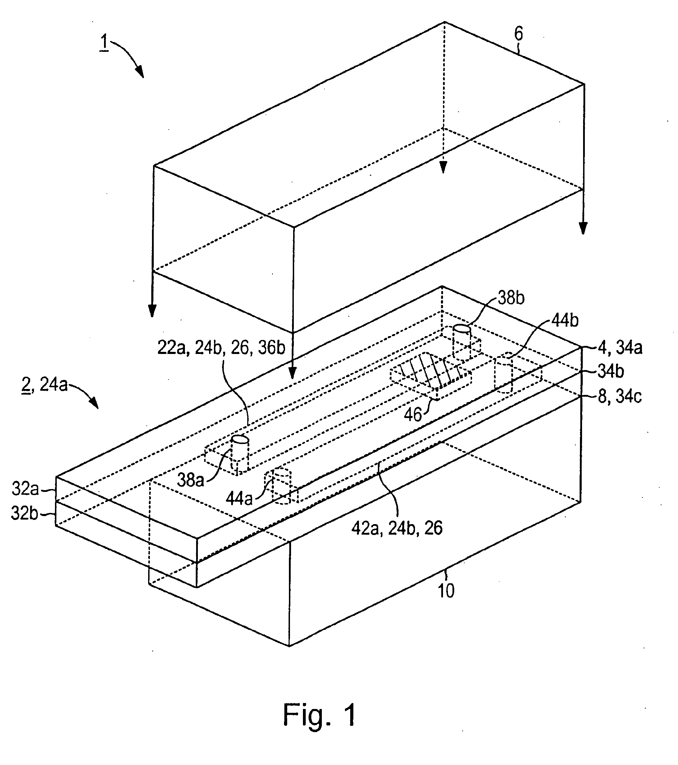

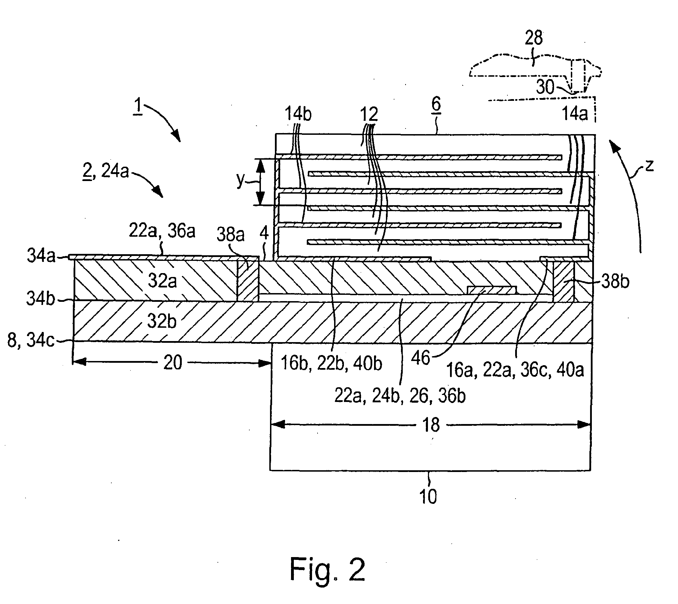

Der in den Figuren 1 und 2 dargestellte piezoelektrische Biegewandler 1 verfügt über einen länglichen, platten- oder leistenartig ausgeführten Tragkörper 2, der an einer oberen Längsseite 4 mit einem Piezo-Körper 6 und an einer unteren Längsseite 8 mit einem Piezo-Körper 10 bestückt ist.

Der Piezo-Körper 6,10 kann einen ein- oder mehrschichtigen Aufbau aufweisen. Im Ausführungsbeispiel ist der Piezo-Körper 6 in Multilayer-Technologie ausgeführt. Er enthält, wie insbesondere Figur 2 verdeutlicht, eine Mehrzahl ebener Piezo-Materialschichten 12. Als Material für den Piezo-Körper 6,10 kann jeder piezoelektrische Werkstoff verwendet werden, vorzugsweise eine Piezo-Keramik, z.B. Blei-Zirkonat-Titan-Keramik. Die Piezo-Materialschichten 12 verlaufen parallel zu der oberen Längsseite 4 des Tragkörpers 2.

Zwischen benachbarten Piezo-Materialschichten 12 erstreckt sich jeweils eine Elektrode 14a,b mit flächiger Ausdehnung, vorzugsweise in Gestalt einer Silber-Palladium-Metallisierungsschicht. Dabei sind die erste Elektrode 14a und die zweite Elektrode 14b abwechselnd, wie in Figur 2 dargestellt, in der Stapelrichtung Y vorgesehen. Damit ist jede Piezo-Materialschicht 12 - beim Ausführungsbeispiel mit Ausnahme der untersten und der obersten Piezo-Materialschicht 12 - auf entgegengesetzten Seiten von der ersten und zweiten Elektrode 14a,b flankiert. Zudem sind sowohl die erste Elektrode 14a als auch die zweite Elektrode 14b untereinander elektrisch verbunden und mit einer ersten bzw. zweiten Kontaktierungsfläche 16a,b verschaltet, die an der sich unmittelbar an den Tragkörper 2 anschließenden untersten Piezo-Materialschicht 12 vorgesehen ist.

Wie in Figur 2 verdeutlicht, belegt der Piezo-Körper 6,10 nur einen Teil der Baulänge der Längsseite 4,8 des Tragkörpers 2. Dieser belegte Teil wird auch als Bestückungsbereich 18 bezeichnet. Daher ragt der Tragkörper 2 mit einem Anschlussabschnitt 20 über den Piezo-Körper 6,10 hinaus. Über diesen Anschlussabschnitt 20 werden die für den Betrieb des piezoelektrischen Biegewandlers 1 erforderlichen elektrischen Anschlüsse vorgenommen, und über ihn kann auch die Einspannung des piezoelektrischen Biegewandlers 1 erfolgen.

Zur Ansteuerung des Piezo-Körpers 6 ist der Tragkörper 2 mit von leitfähigen Kunststoffschichten und/oder Metallisierungen, beispielsweise aus Kupfer, gebildeten ersten und zweiten elektrischen Leitern 22a,b ausgestattet. Über sie lässt sich der Piezo-Körper 6 mit einer Ansteuerspannung beaufschlagen, die eine Längenänderung der Piezo-Materialschichten 12 hervorruft. Diese Längenänderung der Piezo-Materialschichten 12 bewirkt bei dem im Bereich des Anschlussabschnittes 20 eingespannten piezoelektrischen Biegewandler 1 eine Krümmung sowie eine damit verbundene Auslenkung senkrecht zur Längsrichtung des uneingespannten vorderen Endbereichs des piezoelektrischen Biegewandlers 1 gemäß Pfeil z in Figur 2.

Für den Einsatz des piezoelektrischen Biegewandlers 1 sind insbesondere als charakteristische Parameter dessen Stellweg und dessen Stellkraft von Bedeutung. Zur zuverlässigen Anpassung des piezoelektrischen Biegewandlers 1 an eine besonders große Vielzahl möglicher Einsatzgebiete mit einfachen Mitteln kann der durch die sich wechselseitig beeinflussenden Materialeigenschaften des Tragkörpers 2 und des Piezo-Körpers 6,10 insgesamt verfügbare Parameterbereich beeinflusst werden, indem der Tragkörper 2 bezüglich seiner mechanischen Eigenschaften geeignet variiert wird.

Zu diesem Zweck ist der Tragkörper 2 im Ausführungsbeispiel hinsichtlich seines strukturellen Aufbaus mehrkomponentig ausgestaltet. Zusätzlich zu einem bisherigen Trägermaterial 24a ist nämlich eine Anzahl von aus einem weiteren Material 24b aufgebauten Strukturelementen 26 mit im Vergleich zum Trägermaterial 24a unterschiedlichen mechanischen Eigenschaften in das Innere des Tragkörpers 2 eingebracht, deutlich dargestellt in Figur 1.

So ist der Tragkörper 2 des Piezo-Körpers 6,10 zur gezielten Einstellung der Biegeeigenschaften des piezoelektrischen Biegewandlers 1 bei dessen Herstellung partiell mit starren und flexiblen Materialien ausgestaltet. Als Kriterium für die Festigkeit eines Materials kann deren Elastizitätsmodul (E-Modul) dienen. Daher weisen die Strukturelemente 26 des weiteren Materials 24b einen E-Modul auf, der verschieden von dem des Trägermaterials 24a ist. Wenn Strukturelemente 26 mit größeren E-Modulen im Vergleich zu denen des Trägermaterials 24a in den Tragkörper 2 eingebracht sind, wird die Arbeitsgerade des piezoelektrischen Biegewandlers 1 gezielt in Richtung größerer Stellkräfte verschoben. Alternativ erfolgt durch Strukturelemente 26 mit entsprechend kleineren E-Modulen eine gezielte Verschiebung der Arbeitsgerade des piezoelektrischen Biegewandlers 1 in Richtung größerer Stellwege.

Neben der geeigneten Materialwahl ist zur gezielten Anpassung der Biegeeigenschaften des piezoelektrischen Biegewandlers 1 an einen vorgegebenen Einsatzzweck, insbesondere für lokal unterschiedliche mechanische Wirkungen und Beanspruchungen, die Positionierung und die Ausdehnung der Strukturelemente 26 im Tragkörper 2 in besonders vorteilhafter Ausgestaltung auf den Bestückungsbereich 18 mit dem Piezo-Körper 6,10 beschränkt, wie in den Figuren 1 und 2 dargestellt.

Durch die Ausgestaltung eines flexiblen Trägermaterials 24a, wie z.B. Polyimid-Folie, mit versteifenden Strukturelementen 26, z.B. bestehend aus einer Nickel-Basis-Legierung P2918 oder Aluminium, begrenzt auf den Bestückungsbereich 18 des Piezo-Körpers 6,10, kann der piezoelektrische Biegewandler 1 fest in ein Gehäuse eingespannt werden, ohne mechanischen Druck auf die Piezokeramik des Piezo-Körpers 6,10 aufzubringen und ihn somit zu schädigen.

Als eine mögliche vorteilhafte Verwendung ist der piezoelektrische Biegewandler 1 im Ausführungsbeispiel als Stellglied in einem zur Steuerung von Fluidströmen dienenden Ventil eingesetzt. In Figur 2 ist daher strichpunktiert ein Ausschnitt eines Ventilgehäuses 28 angedeutet, das über eine Fluidkanalmündung 30 verfügt, die durch Aktivieren bzw. Deaktivieren des piezoelektrischen Biegewandlers 1 durch diesen wahlweise verschlossen oder freigegeben wird.
Wie insbesondere aus den Figuren 1 und 2 ersichtlich, ist der Tragkörper 2 mehrschichtig ausgeführt. In der Ausführungsform liegen beispielhaft zwei Tragkörperschichten 32a,b mit diesen zugeordnetenn drei Bestückungsebenen, nämlich einer oberen, einer mittleren und einer unteren Bestückungsebene 34a,b,c vor.

Die ersten elektrischen Leiter 22a verlaufen sowohl in der oberen Bestückungsebene 34a, als auch zum Schutz vor mechanischen oder chemischen Einflüssen teilweise im Inneren des Tragkörpers 2, also hier in der mittleren Bestückungsebene 34b. Dazu sind die ersten elektrischen Leiter 22a in mehrere Leiterabschnitte 36a,b,c unterteilt und mittels Durchkontaktierungen 38a,b, sogenannte Vias aus elektrisch leitfähigen Materialien, beispielsweise aus einem Leitkleber, miteinander verknüpft. So erstreckt sich ein erster Leiterabschnitt 36a im Bereich des Anschlussabschnittes 20 auf der oberen Längsseite 4 und der von dieser definierten oberen Bestückungsebene 34a. Noch vor Erreichen des Piezo-Körpers 6 ist eine die erste Tragkörperschicht 32a durchsetzende Durchkontaktierung 38a vorgesehen, die zu der mittleren Bestückungsebene 34b führt, welche vom Übergangsbereich zwischen den beiden Tragkörperschichten 32a,b gebildet ist. Dort schließt sich ein zweiter Leiterabschnitt 36b der ersten elektrischen Leiter 22a an. Mit einer weiteren Durchkontaktierung 38b wird die erste Tragkörperschicht 32a erneut durchsetzt und der zweite Leiterabschnitt 36b mit dem dritten Leiterabschnitt 36c verbunden, welcher sich in der oberen Bestückungsebene 34a auf der oberen Längsseite 4 befindet. Die Anzahl der Durchkontaktierungen 38a,b ist dabei prinzipiell beliebig und orientiert sich am gewünschten Schaltungs-Layout.

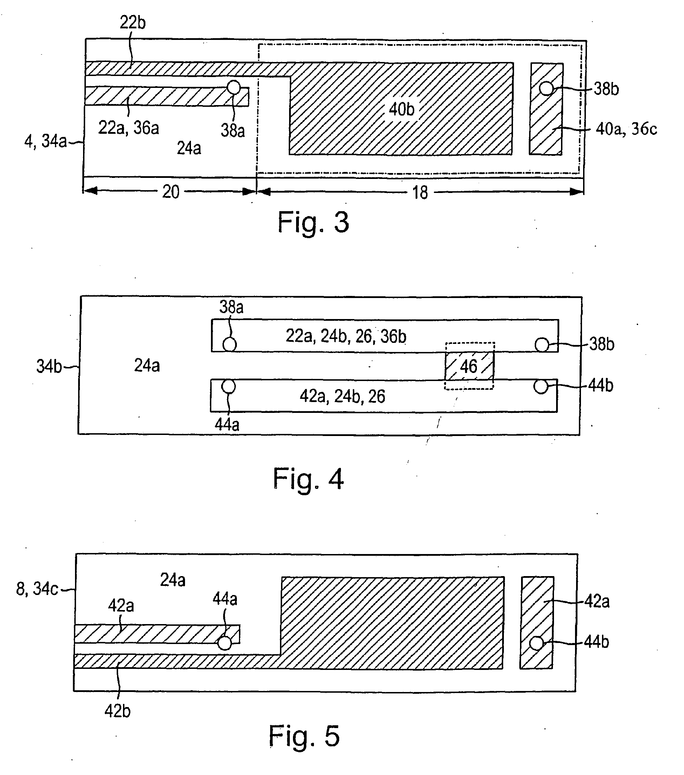

Figur 3 zeigt den strukturellen Aufbau der oberen Bestükkungsebene 34a. In ihr verlaufen die ersten und zweiten elektrischen Leiter 22a,b in Form von aufgedampftem Kupfer im nm Bereich ausgehend vom freien stirnseitigen Ende des Anschlussabschnittes 20 bis in den Bestückungsbereich 18 für den Piezo-Körper 6, wo die ersten elektrischen Leiter 22a als erste Verbindungsfläche 40a und die zweiten elektrischen Leiter 22b als zweite Verbindungsfläche 40b ausgeführt sind. Diese sind mit der ersten bzw. der zweiten Kontaktierungsfläche 16a,b des Piezo-Körpers 6 elektrisch kontaktiert.

Figur 4 zeigt, dass im Ausführungsbeispiel die ersten elektrischen Leiter 22a für den Piezo-Körper 6 im Inneren des Tragkörpers 2, also in der mittleren Bestückungsebene 34b, zugleich als Strukturelemente 26 ausgebildet sind. Dafür bestehen sie vorteilhafterweise aus sogenannten Kupfer-Pads mit einer Dicke im µm Bereich, vorzugsweise in der Größe von 17, 35 oder 50 µm. Diese besondere Ausbildung gewährleistet die Funktion sowohl als elektrische Leiter für den Piezo-Körper 6 als auch, wie oben für die Strukturelemente 26 beschrieben, als lokaler Regulator für spezifische mechanische Biegeeigenschaften des piezoelektrischen Biegewandlers 1. Durch die mit der Akkumulation oder Vereinigung der Funktionen der ersten elektrischen Leiter 22a auf die Strukturelemente 26 vice versa einhergehende Platzeinsparung ist ein auf das Gebiet der Mikrosystemtechnik erweitertes Anwendungsfeld für den piezoelektrischen Biegewandlers 1 möglich.

In der von der unteren Längsseite 8 des Tragkörpers 2 repräsentierten unteren Bestückungsebene 34c, wie in Figur 5 gezeigt, sind weitere elektrische Leiter 42a,b und Durchkontaktierungen 44a,b - vergleichbar den oben im Detail geschilderten ersten und zweiten elektrischen Leitern 22a,b und Durchkontaktierungen 38a,b - vorgesehen, die die Ansteuerung des an der unteren Längsseite 8 positionierten zweiten Piezo-Körpers 10 gestatten. Im Ausführungsbeispiel bestehen dabei die weiteren elektrischen Leiter 42a,b aus aufgedampften Kupfer im nm Bereich, während die in der mittleren Bestückungsebene 34b, ersichtlich in Figur 4, fortgeführten elektrischen Leiter 42a als Kupfer-Pads mit einer Dicke im µm Bereich, vorzugsweise mit einer Größe von 17, 35 oder 50 µm ausgestaltet sind, die wiederum als Strukturelemente 26, wie oben beschrieben, fungieren.

Im Ausführungsbeispiel ist gut geschützt im Inneren des Tragkörpers 2, beispielsweise zwischen zwei flächig aufeinanderliegenden Tragkörperschichten 32a,b, eine Anzahl von Komponenten einer Ansteuer-, Sensor- oder Arbeitselektronik 46 untergebracht, wie in den Figuren 1, 2 und 4 dargestellt. Damit ist eine modulare und insbesondere im Hinblick auf mikrosystemtechnische Anwendungen zugleich eine integrierte Bauweise und geringe Baugröße des piezoelektrischen Biegewandlers 1 mit der für seinen Betrieb verwendeten Elektronik 46 gewährleistet.

## Patentansprüche

1. Piezoelektrischer Biegewandler (1) mit einem länglichen Tragkörper (2), der an wenigstens einer Längsseite (4 bzw. 8) mit einem Piezo-Körper (6 bzw. 10) bestückt ist, bei dem im Inneren des ein Trägermaterial (24a) umfassenden Tragkörpers (2) eine Anzahl von aus einem weiteren Material (24b) mit im Vergleich zum Trägermaterial (24a) unterschiedlichen mechanischen Eigenschaften aufgebauten Strukturelementen (26) angeordnet ist.

2. Piezoelektrischer Biegewandler (1) nach Anspruch 1, bei dem die Strukturelemente (26) einen Elastizitätsmodul (E-Modul) aufweisen, der verschieden von dem des Trägermaterials (24a) ist.

3. Piezoelektrischer Biegewandler (1) nach Anspruch 1 oder 2, bei dem die Anordnung der Strukturelemente (26) im Tragkörper (2) auf den Bestückungsbereich (18) mit dem Piezo-Körper (6,10) beschränkt ist.

4. Piezoelektrischer Biegewandler (1) nach einem der vorhergehenden Ansprüche, bei dem der Tragkörper (2) mehrere Tragkörperschichten (30a,b) mit zugeordneten Bestückungsebenen (34a,b,c) aufweist.

5. Piezoelektrischer Biegewandler (1) nach Anspruch 4, bei dem der Tragkörper (2) mit elektrischen Leitern (22a,b bzw. 42a,b) für den Piezo-Körper (6 bzw. 10) versehen ist, die zumindest teilweise in innen liegenden Bestückungsebenen (34b) des Tragkörpers (2) angeordnet sind.

6. Piezoelektrischer Biegewandler (1) nach Anspruch 5, bei dem die elektrischen Leiter (22a,b bzw. 42a,b) für den Piezo-Körper (6 bzw. 10) an zur Herstellung einer vorgegebenen Verschaltung geeigneten Verbindungsstellen miteinander oder mit dem Piezo-Körper (6 bzw. 10) über quer zu den Tragkörperschichten (32a,b) verlaufende Durchkontaktierungen (38a,b bzw. 44a,b) verbunden sind.

7. Piezoelektrischer Biegewandler (1) nach einem der vorhergehenden Ansprüche, bei dem die Strukturelemente (26) als elektrische Leiter (22a,b bzw. 42a,b) für den Piezo-Körper (6 bzw. 10) ausgebildet sind.

8. Piezoelektrischer Biegewandler (1) nach einem der vorhergehenden Ansprüche, bei dem direkt auf und/oder im Inneren des Tragkörpers (2) eine Anzahl von Komponenten einer Ansteuer-, Sensor- oder Arbeitselektronik (46) untergebracht ist.

9. Verwendung eines piezoelektrischen Biegewandlers (1) nach einem der vorhergehenden Ansprüche als Stellglied für mikrosystemtechnische Anwendungen, insbesondere für Mikropumpen und/oder Mikrodispensiersysteme und/oder Mikroventile.
